# FASCICULE DE BREVET EUROPEEN

(11) **EP 3 563 647 B1**
(45) Date de publication et mention de la délivrance du brevet: **07.04.2021**
(21) Numéro de dépôt: 17825868.7
(22) Date de dépôt: 22.12.2017
(51) Int. Cl.: H05K 1/02, H05B 33/08, F21S 4/00

(54) **STRUCTURE ELECTRONIQUE COMPRENANT UNE MATRICE DE DISPOSITIFS ELECTRONIQUES PRESENTANT DES PERFORMANCES THERMIQUES AMELIOREES**
ELEKTRONISCHE STRUKTUR MIT EINEM MATRIX-ARRAY AUS ELEKTRONISCHEN VORRICHTUNGEN MIT VERBESSERTEN THERMISCHEN LEISTUNGEN
ELECTRONIC STRUCTURE COMPRISING A MATRIX ARRAY OF ELECTRONIC DEVICES HAVING IMPROVED THERMAL PERFORMANCES

(30) Priorité: 30.12.2016 FR 1663544
(43) Date de publication de la demande: 06.11.2019
(73) Titulaire: Commissariat à l'Énergie Atomique et aux Énergies Alternatives, 75015 Paris (FR)
(72) Inventeur: CHAMBION, Bertrand, 38530 Pontcharra (FR)
(74) Mandataire: Cabinet Camus Lebkiri
(86) Numéro de dépôt international: PCT/EP2017/084470
(87) Numéro de publication internationale: WO 2018/122188

(56) Documents cités:
- GB-A- 2 501 758
- US-A1- 2010 320 483
- US-A1- 2011 309 381
- US-A1- 2014 232 288
- US-A1- 2014 247 597
- US-A1- 2016 178 177

## Description

### DOMAINE TECHNIQUE DE L'INVENTION

La présente invention concerne les structures électroniques comprenant des dispositifs électroniques agencés sous la forme d'une matrice, et plus particulièrement l'amélioration des performances thermiques d'une telle structure.

La présente invention s'applique particulièrement, mais non exclusivement, aux structures de dispositifs émetteurs de lumière destinées à un fonctionnement à haute tension.

### ARRIÈRE-PLAN TECHNOLOGIQUE DE L'INVENTION

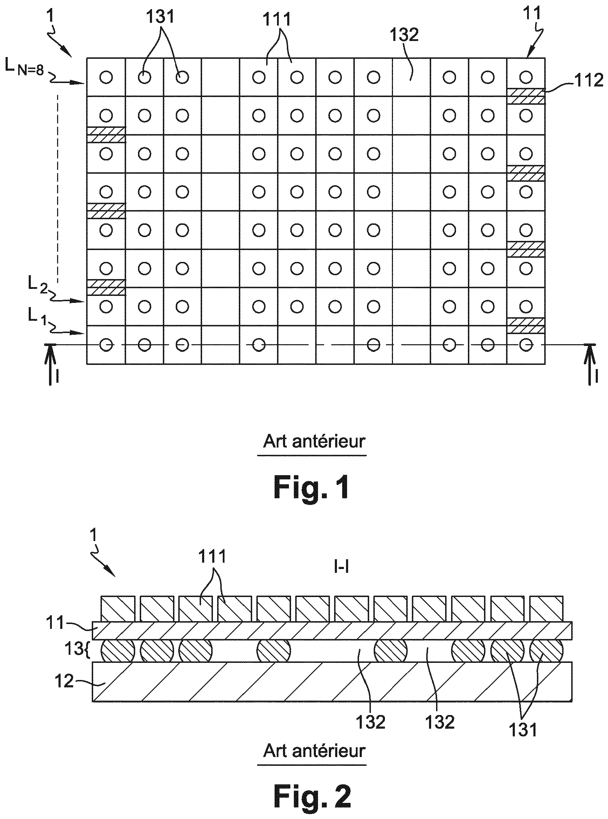

Il existe des structures de diodes électroluminescentes destinées à un fonctionnement à haute tension, c'est-à-dire pouvant être directement alimentées par une tension d'alimentation alternative délivrée par un réseau d'alimentation électrique, tel que le réseau domestique. Une telle structure 1 est illustrée en vue de dessus sur la figure 1. La structure 1 comporte une pluralité de diodes électroluminescentes 111 agencées sous la forme d'une matrice 11 comprenant un nombre N de lignes Lᵢ d'indice i, i étant un nombre entier naturel compris entre 1 et N. Par exemple, le nombre N de lignes dans la matrice 11 de la figure 1 est égal à 8. Les diodes électroluminescentes 111 de chaque ligne Lᵢ sont connectées en série. De plus, les lignes Lᵢ peuvent être connectées en série au moyen de commutateurs 112 disposés en bout de ligne, comme illustré sur la figure 1.

La figure 2 est une vue en coupe de la structure 1 selon le plan de coupe I-I de la figure 1. La structure 1 comporte un dispositif de contrôle 12 configuré pour piloter les commutateurs 112 de manière dynamique. Les deux composants que sont la matrice 11 et le dispositif de contrôle 12 sont fabriqués indépendamment l'un de l'autre avant d'être assemblés l'un sur l'autre au moyen d'une couche d'interconnexion 13, ce qui explique cette dénomination de structure. La couche d'interconnexion 13 comporte des billes 131 d'un matériau fusible qui forment des connexions électriques, mécaniques et thermiques entre la matrice 11 et le dispositif de contrôle 12. Ce type d'assemblage, dit « à puce retournée » ou « flip-chip » en anglais, est connu de l'industrie microélectronique. Les billes 131 agissent comme des drains thermiques afin d'évacuer la chaleur générée par les diodes électroluminescentes 111 qui sont la principale source de chaleur dans la structure 1.

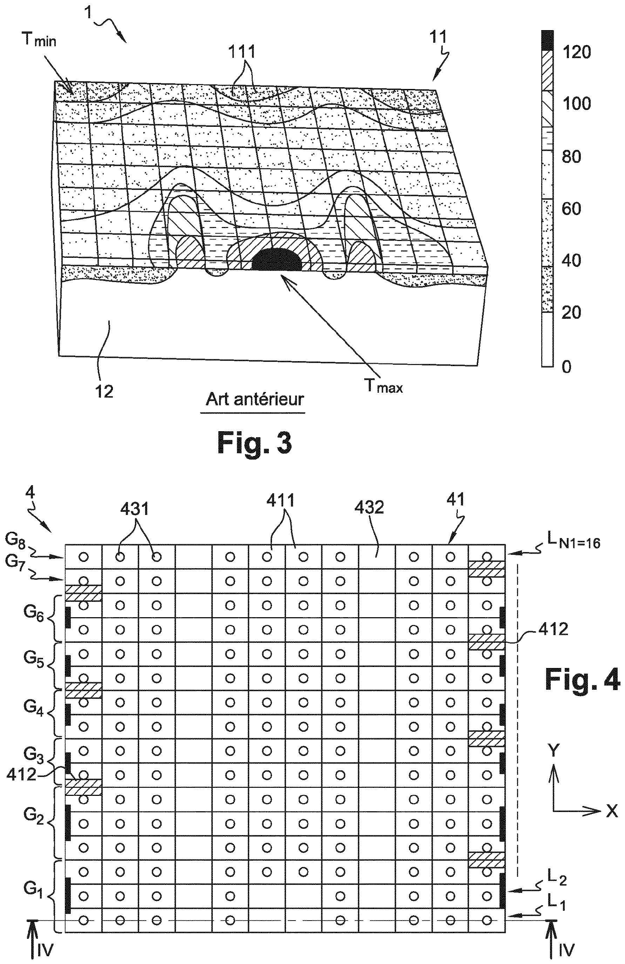

Le dispositif de contrôle 12 détermine la valeur de la tension d'alimentation fournie en entrée de la structure 1 et, en fonction de cette valeur, alimente autant de lignes Lᵢ que possible en les connectant en série. Lorsque la tension d'alimentation augmente, les lignes Lᵢ de la matrice 11 sont connectées en série en suivant un ordre croissant des indices i des lignes Lᵢ, c'est-à-dire en commençant par la première ligne L₁ pour terminer par la dernière ligne L_{N}. Lorsque la tension d'alimentation diminue, les lignes Lᵢ sont déconnectées en suivant l'ordre inverse, c'est-à-dire en commençant par la dernière ligne L_{N} pour terminer par la première ligne L₁. Par conséquent, la première ligne L₁ est plus souvent alimentée que la dernière ligne L_{N}. Il en résulte une consommation d'énergie électrique qui n'est pas répartie de façon homogène entre les différentes lignes Lᵢ de la matrice 11, ce qui se traduit par des écarts de températures au sein de la matrice 11. Ce phénomène est illustré sur la figure 3.

La figure 3 est une cartographie de la température en surface de la matrice 11 de la figure 1. Les diodes électroluminescentes 111 présentent une température limite de fonctionnement d'environ 150 °C, température au-delà de laquelle elles sont endommagées. La figure 3 montre qu'une température maximale Tₘₐₓ d'environ 130 °C, proche de la température limite, est atteinte au niveau de la première ligne L₁. Les diodes électroluminescentes 111 de la première ligne L₁ risquent donc de se dégrader.

La figure 3 montre également qu'une température minimale Tₘᵢₙ d'environ 33 °C est obtenue au niveau de la dernière ligne L_{N}. Les écarts de températures auxquels la matrice 11 est soumise sont importants, avec un gradient thermique pouvant atteindre presque 100 °C. Ce gradient thermique élevé implique des conséquences thermomécaniques dommageables pour la matrice 11. En effet, les zones chaudes de la matrice 11 vont davantage se dilater que les zones froides, ce qui peut aboutir à la formation de fissures dans la matrice 11, ou dans le pire des cas à une rupture de la matrice 11.

Ce phénomène de gradient thermique est accentué par des contraintes liées à l'assemblage de la matrice 11 sur le dispositif de contrôle 12. Idéalement, une bille 131 devrait être disposée sous chaque diode électroluminescente 111 pour dissiper un maximum de chaleur. En pratique, il n'est cependant pas possible de placer une bille 131 sous certaines diodes électroluminescentes 111, par exemple lorsque la zone du dispositif de contrôle 12 située en vis-à-vis comporte un élément sensible, pour des problématiques de densité d'intégration, de contraintes de dessin de circuit, ou encore de contraintes de passage de pistes d'alimentation. La couche d'interconnexion 13 présente des emplacements libres 132 dépourvus de bille, comme illustré sur les figures 1 et 2. C'est le cas en particulier de la première ligne L₁ dont la température est la plus élevée

Le document US2011/0309381 décrit un dispositif sous forme d'une matrice, comportant des diodes électroluminescentes connectés en série et arrangés dans plusieurs groupes qui sont eux connectés en parallèle.

Il apparaît donc un besoin de perfectionner la structure de diodes électroluminescentes pour réduire les écarts de températures dans la matrice de diodes électroluminescentes.

### RÉSUMÉ DE L'INVENTION

La présente invention vise à améliorer la répartition de la charge thermique dans une matrice de dispositifs électroniques appartenant à une structure électronique.

Selon l'invention, ce but est atteint en prévoyant une structure électronique comprenant une pluralité de dispositifs électroniques agencés sous la forme d'une matrice comportant un premier nombre de lignes, les dispositifs électroniques de chaque ligne étant connectés en série, la matrice comportant en outre une pluralité de commutateurs, les lignes de la matrice étant réparties en un deuxième nombre de groupes étant connectés en série au moyen des commutateurs, les groupes connectés en série étant alimentés par un courant d'alimentation électrique, au moins l'un des groupes comportant au moins deux lignes connectées en parallèle de manière à répartir le courant d'alimentation entre lesdites au moins deux lignes.

On entend par « structure électronique » un dispositif comportant au moins deux composants électronique fabriqués séparément et assemblés l'un sur l'autre par l'intermédiaire d'une couche d'interconnexion comprenant par exemple des billes de soudures. Un tel assemblage est dit « à puce retournée » ou « flip-chip » en anglais.

Les groupes de la matrice présentent chacun une surface active qui dépend du nombre de lignes qu'ils comportent. Plus ce nombre est élevé, plus la surface active du groupe est grande. Grâce à l'invention, il est possible d'affecter la surface active souhaitée à un groupe pour améliorer la répartition de la puissance électrique injectée dans ce groupe.

Dans la suite de la description, le terme « taille », lorsqu'il est utilisé en référence à un groupe de lignes, désigne indifféremment la surface active du groupe ou le nombre de lignes que comporte le groupe.

Dans une structure de l'art antérieur, il est possible de considérer que les groupes sont tous constitués d'une seule ligne. Tous les groupes ont donc la même taille. Au contraire, dans la structure selon l'invention, les groupes ont des tailles qui peuvent être différentes. Un autre avantage de l'invention est donc de définir des groupes de tailles différentes tout en conservant une matrice régulière, c'est-à-dire en faisant en sorte que les dispositifs électroniques aient tous sensiblement les mêmes dimensions. Cela permet de faciliter la mise en œuvre de l'assemblage à puce retournée, qui est préférablement effectuée avec une matrice régulière.

Selon un mode de réalisation, la structure comporte un dispositif de contrôle pilotant les commutateurs de la matrice pour connecter en série les groupes selon un ordre prédéterminé. Chaque groupe comporte un nombre de lignes connectées en parallèles décroissant selon l'ordre dans lequel les groupes sont connectés en série. Un avantage est d'adapter la surface active de chaque groupe en lui attribuant plus ou moins de lignes en fonction d'une puissance électrique injectée dans le groupe et du nombre total de groupes sur la puce.

Selon un mode de réalisation, les groupes sont formés par des lignes adjacentes. Un avantage est de faciliter la réalisation des connexions en parallèle des lignes, et donc la fabrication de la matrice.

Selon un mode de réalisation, la matrice comporte au moins deux fois plus de lignes que de groupes. Un avantage est d'avoir un ratio entre le nombre de lignes et le nombre de groupes suffisamment élevé pour permettre de faciliter la répartition.

Selon un mode de réalisation, le premier nombre de lignes de la matrice est un deuxième nombre multiple entier du nombre de groupes.

Selon un mode réalisation, la matrice consomme une puissance électrique totale, le premier nombre de lignes de la matrice étant suffisamment élevé pour que chaque groupe consomme une puissance électrique telle que l'écart entre la puissance totale divisée par le nombre de groupes et la puissance de chaque groupe est inférieur à 40%. Un avantage est de maintenir le gradient thermique présent dans la matrice sous une valeur prédéterminée.

Selon un mode de réalisation, les dispositifs électroniques sont des dispositifs émetteurs de lumière.

Selon un mode de réalisation, les dispositifs émetteurs de lumière sont des diodes électroluminescentes planaires.

Selon un mode de réalisation, les dispositifs émetteurs de lumière sont des diodes électroluminescentes à nano ou à micro-fils.

### BRÈVE DESCRIPTION DES FIGURES

L'invention et ses différentes applications seront mieux comprises à la lecture de la description qui suit et à l'examen des figures qui l'accompagnent, parmi lesquelles :
- la figure 1 est une vue de dessus schématique d'une structure de diodes électroluminescentes selon l'art antérieur ;
- la figure 2 est une vue schématique en coupe de la structure de la figure 1 selon le plan de coupe I-I ;
- la figure 3 est une cartographie de la température en surface d'une matrice de diodes électroluminescentes appartenant à la structure de la figure 1 ;
- la figure 4 est une vue de dessus schématique d'une structure de diodes électroluminescentes selon l'invention ;
- la figure 5 est une vue schématique en coupe de la structure de la figure 4 selon le plan de coupe IV-IV;
- la figure 6 représente un exemple d'une tension d'alimentation de la structure de la figure 4 ;
- la figure 7 représente la densité moyenne de courant électrique présente dans chaque groupe de la structure de la figure 4 et dans chaque ligne de la structure de la figure 1, les deux structures étant alimentées par la tension d'alimentation de la figure 6;
- la figure 8 est une cartographie de la température en surface d'une matrice de diodes électroluminescentes appartenant à la structure de la figure 4 ;

Les figures ne sont présentées qu'à titre indicatif et nullement limitatif de l'invention.

Pour plus de clarté, les éléments identiques ou similaires sont repérés par des signes de référence identiques sur toutes les figures.

### DESCRIPTION DÉTAILLÉE DE MODES DE REALISATION DE L'INVENTION

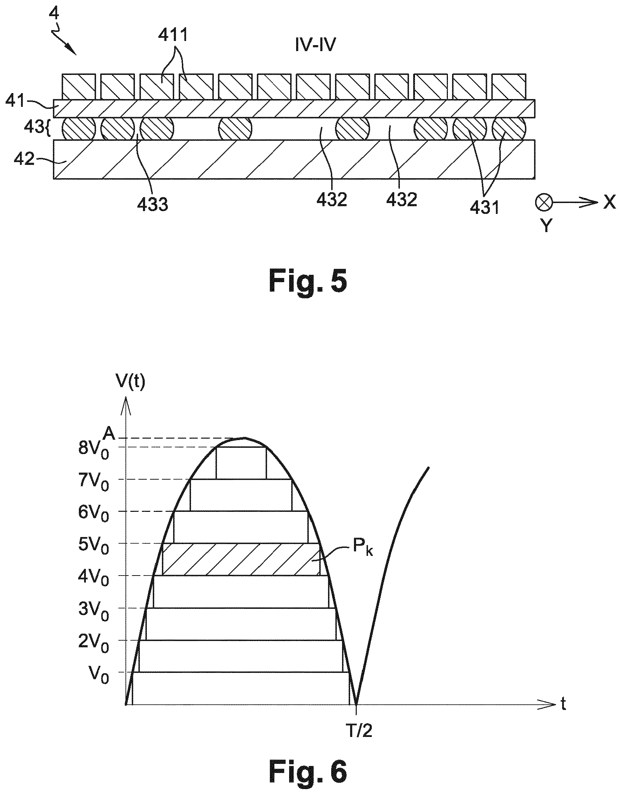

Un mode de réalisation d'une structure électronique 4 selon l'invention va maintenant être décrit en référence aux figures 4 et 5. La structure 4 comporte un premier composant 41, en l'occurrence une matrice 41 de diodes électroluminescentes 411, et un deuxième composant 42, en l'occurrence un dispositif de contrôle 42 permettant d'adresser la matrice 41. Ces deux composants 41, 42 sont fabriqués indépendamment l'un de l'autre, chacun sur son propre substrat, par exemple en silicium. La matrice 41 et le dispositif de contrôle 42 fonctionnent de manière complémentaire et sont assemblés au moyen d'une couche d'interconnexion 43 disposée entre la matrice 41 et le dispositif de contrôle 42.

Chaque diode électroluminescente 411 forme un pixel 411 de la matrice 41. Les diodes électroluminescentes 411 peuvent être des diodes planaires, également dites diodes en deux dimensions (2D), ou des diodes à nano ou à micro-fils. Les diodes électroluminescentes 411 sont de préférence identiques.

La matrice 41 comporte un premier nombre N1 de lignes Lj (j étant un nombre entier naturel compris entre 1 et N1) s'étendant selon une première direction X. Par exemple, le nombre N1 de lignes Lj de la matrice 41 de la figure 4 est égal à 16. Les lignes Lⱼ sont disposées les unes à côté des autres selon une deuxième direction Y orthogonale à la première direction X. Les pixels 411 présentent une première dimension, appelée « largeur », selon la première direction X et une deuxième dimension, appelée « hauteur » selon la deuxième direction Y. Les diodes électroluminescentes 411 de chaque ligne Lj sont connectées en série. Les lignes Lj de la matrice 41 de la figure 4 comportent un même nombre de pixels, par exemple égal à 12.

Les lignes Lⱼ de la matrice 41 sont réparties en un deuxième nombre N2 de groupes Gₖ (k étant un nombre entier naturel compris entre 1 et N2), chaque groupe Gₖ comportant soit une seule ligne, soit plusieurs lignes connectées en parallèle. Les lignes Lⱼ constituant les groupes Gₖ sont connectées en parallèle de manière figée, c'est-à-dire lors de la fabrication de la matrice 41. De préférence, les lignes Lj que comporte chaque groupe Gₖ sont adjacentes. Ainsi, la connexion en parallèle de telles lignes est simple à réaliser, ce qui facilite la fabrication de la matrice 41. Par exemple, le nombre N2 de groupes Gₖ dans la matrice 41 de la figure 4 est égal à 8, les deux premiers groupes G₁ et G₂ comportant chacun 3 lignes Lⱼ connectées en parallèle, les groupes G₃ à G₆ comportant chacun 2 lignes Lⱼ connectées en parallèle, et les deux derniers groupes G₇ et G₈ ne comportant chacun qu'une seule ligne Lⱼ. La manière selon laquelle est effectuée cette répartition sera décrite plus en détail par la suite.

La matrice 41 comporte également des commutateurs 412 commandés de manière dynamique par le dispositif de contrôle 42 pour connecter en série les groupes Gₖ. Les commutateurs 412 sont disposés en bout de ligne, tel qu'illustré sur la figure 4.

La couche d'interconnexion 43 comporte de préférence des billes de soudures 431 disposées sous les pixels de la matrice selon un motif d'interconnexion prédéterminé lié aux contraintes d'assemblage de la matrice sur le dispositif de contrôle. Du fait de ces contraintes, la couche d'interconnexion 43 présente des emplacements libres 432 dépourvus de bille. La couche d'interconnexion 43 comporte également un matériau de remplissage 433 qui comble l'espace libre entre les billes 431. Le matériau de remplissage 433 peut être un matériau organique, tel qu'une résine époxy ou du silicone, chargé ou non. Le matériau de remplissage 433 assure la tenue mécanique de l'assemblage.

Chaque bille 431 forme une connexion mécanique et thermique entre la matrice 41 et le dispositif de contrôle 42. Il est à noter que les emplacements libres 432 offrent une dissipation thermique plus faible que les billes 431, dans un rapport de l'ordre de 5. Les billes 431 sont formées à partir d'un matériau fusible conducteur électriquement. Une couche de passivation (non représentée) est avantageusement intercalée entre les billes 431 et la matrice 41 pour isoler électriquement la matrice du dispositif de contrôle 42. La couche de passivation comporte des ouvertures situées sous certains pixels. En plus d'une connexion mécanique et thermique, une bille placée en correspondance avec une ouverture forme également une connexion électrique entre la matrice 41 et le dispositif de contrôle 42. Des ouvertures sont notamment présentes sous les pixels 411 disposés en bout de ligne, ces pixels 411 constituant des points d'entrée et de sortie du courant électrique.

En fonctionnement, la structure 4 est alimentée par une tension d'alimentation alternative. La tension d'alimentation V(t) peut provenir d'un réseau d'alimentation électrique tel que le réseau domestique. La figure 6 montre un exemple d'une tension d'alimentation sinusoïdale V(t) appliquée à la structure 4, cette tension V(t) présentant une période T et une amplitude A. De préférence, la tension d'alimentation V(t) est redressée avant d'être appliquée en entrée de la structure 4.

Le dispositif de contrôle 42 est par exemple un circuit intégré à application spécifique (ASIC pour « Application-Specific Integrated Circuit » en anglais). Il a notamment pour fonction de déterminer le nombre de groupes Gₖ à alimenter en fonction de la valeur de la tension d'alimentation à un instant donné. Chaque groupe Gₖ présente une tension seuil Vₖ (k étant un nombre entier naturel compris entre 1 et N2) que le dispositif de contrôle 42 doit fournir à la matrice 41 pour alimenter le groupe Gₖ. Selon le mode de réalisation de la figure 4, toutes les lignes Lⱼ de la matrice 41 comportent le même nombre de pixels. Par conséquent, tous les groupes Gₖ ont sensiblement la même tension seuil V₀. A chaque fois que la tension d'alimentation atteint un multiple de la tension seuil V₀, un groupe supplémentaire est alimenté en étant connecté en série, par l'intermédiaire des commutateurs 412, avec les groupes déjà alimentés.

De façon plus détaillée, lorsque la tension d'alimentation atteint V₀, le premier groupe G₁ est alimenté. Ensuite, lorsque la tension d'alimentation atteint 2V₀, le premier groupe G₁ et le deuxième groupe G₂ sont connectés en série et alimentés. Il en va ainsi jusqu'à l'alimentation de tous les groupes Gₖ de la matrice 41. Lorsque la tension d'alimentation est strictement comprise entre V₀ et 2V₀, la valeur de tension appliquée au premier groupe G₁ est maintenue à V₀. De manière générale, la tension appliquée à chaque ligne Lⱼ est limitée par le dispositif de contrôle 42 à la tension seuil V₀.

La figure 6 montre ainsi la répartition de la puissance électrique Pₖ injectée dans chaque groupe Gₖ sur une demi-période de la tension d'alimentation. Les valeurs numériques de cette puissance, exprimées en Watts, sont reportées dans la table 1 ci-dessous, chaque groupe recevant un courant d'alimentation de 50 mA. La table 1 donne également les valeurs du rapport cyclique de l'alimentation de chaque groupe Gₖ. Cette grandeur traduit la durée, ramenée sur une période T de la tension d'alimentation V(t), pendant laquelle chaque groupe Gₖ est alimenté.

**Table 1**

| Groupe | Rapport cyclique (%) | Puissance moyenne (W) |
|---|---|---|
| G₁ | 91 | 1.7 |
| G₂ | 84 | 1.6 |
| G₃ | 76 | 1.4 |
| G₄ | 68 | 1.3 |
| G₅ | 60 | 1.1 |
| G₆ | 51 | 0.9 |
| G₇ | 40 | 0.7 |
| G₈ | 26 | 0.5 |

La puissance électrique injectée dans chaque groupe Gₖ est directement lié à la fréquence à laquelle il est alimenté. En effet, les groupes Gₖ ont la même tension seuil V₀ et reçoivent un courant électrique qui a sensiblement la même valeur pour tous les groupes Gₖ. Une partie de la puissance électrique est convertie par les diodes électroluminescente 411 en puissance thermique. Autrement dit, lorsqu'elles sont alimentées, les diodes électroluminescente 411 chauffent, et plus elles sont alimentées souvent, plus elles chauffent. Le but de l'invention est d'améliorer la répartition de la puissance électrique injectée dans la matrice 41, et donc d'améliorer la répartition de la chaleur générée par les diodes électroluminescente 411. Pour ce faire, on forme des groupes Gₖ de tailles différentes en connectant en parallèle les lignes Lⱼ de la matrice 41. A puissance égale, une plus grande taille implique une densité de puissance réduite, donc un échauffement moindre.

Les groupes Gₖ sont connectés en série dans un ordre prédéterminé, du premier groupe G₁ au dernier groupe G_{N2}. Par conséquent, plus l'indice k d'un groupe Gₖ est faible, plus la puissance électrique injectée dans ce groupe Gₖ est élevée. Inversement, plus l'indice k d'un groupe Gₖ est élevé, plus la puissance électrique injectée dans ce groupe Gₖ est faible. Selon le mode de réalisation de la figure 4, le nombre de lignes Lⱼ que comporte chaque groupe Gₖ diminue en même temps que l'indice k du groupe Gₖ augmente. Ainsi, la taille et la puissance électrique injectée de chaque groupe Gₖ suivent une même courbe de progression.

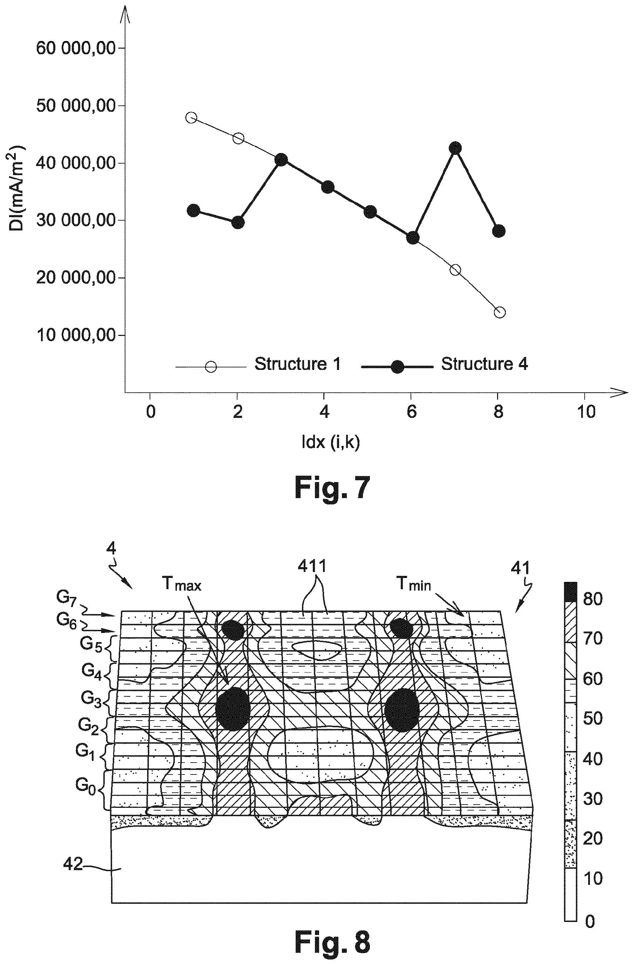

La figure 7 montre une comparaison des densités moyennes de courant électrique DI présentes dans les groupes Gₖ de la structure 4 selon l'invention et dans les lignes Lᵢ la structure 1 de l'art antérieur décrite en référence à la figure 1, en fonction de l'indice Idx de la ligne ou du groupe. La comparaison est d'autant plus appropriée que les matrices 11, 41 des deux structures 1, 4 ont la même taille. La hauteur des pixels 411 de la structure 4 selon l'invention a été divisée par 2 par rapport à la hauteur des pixels 111 de la structure 1 de l'art antérieur, mais la structure 4 compte deux fois plus de lignes (16) que la structure 1 (8). On constate que l'écart entre le maximum et le minimum de la densité de courant DI dans les différentes groupes Gₖ de la structure 4 est plus réduit que dans les différentes lignes Lᵢ dans la structure 1. L'invention permet donc d'homogénéiser la consommation électrique de diodes électroluminescente 411, et donc la charge thermique.

Le gain obtenu au niveau des températures présentes en surface de la matrice 41 de la structure 4 est illustré sur la figure 8. La température maximale Tₘₐₓ est d'environ 86 °C et la température minimale Tₘᵢₙ est d'environ 58 °C. Une meilleure répartition de la chaleur est donc constatée, avec un gradient thermique faible, inférieur à 30°C dans ce cas.

Grâce à l'invention, il est remédié au problème de répartition la charge thermique en allouant à chaque groupe Gₖ une surface adaptée à sa consommation d'énergie électrique tout en conservant une matrice régulière comportant des pixels de dimensions constantes. En effet, l'assemblage de la matrice 41 sur le dispositif de contrôle 42 est préférablement réalisé sur une matrice 41 régulière. Par exemple, une taille de pixels constante permet de disposer des billes de soudures de tailles identiques, ce qui assure la planéité de la structure 1.

La matrice 41 consomme une puissance totale qui peut être calculée. En divisant cette puissance totale par le nombre de groupe Gₖ, on obtient une puissance moyenne par groupe. Avantageusement, les lignes Lⱼ, sont réparties dans les groupes Gₖ de manière à minimiser l'écart entre la puissance moyenne par groupe et la puissance effectivement injectée dans chaque groupe Gₖ afin de répartir la puissance de façon optimale. De préférence, cet écart est fixé inférieur à 40%, et plus préférentiellement encore inférieur à 20%. Plus le nombre N1 de lignes Lⱼ que comporte la matrice 41 est élevé, plus il est possible d'approcher la puissance injectée dans chaque groupe Gₖ de la puissance moyenne.

Naturellement, l'invention n'est pas limitée aux modes de réalisations décrits en référence aux figures et des variantes pourraient être envisagées sans sortir du cadre de l'invention. En particulier, bien que l'invention ait été décrite en relation avec une structure de diodes électroluminescentes, l'invention peut être appliquée à d'autres types de structures électroniques comportant des dispositifs électroniques agencés sous la forme d'une matrice, ces structures présentant des problématiques similaires de distribution d'énergie au sein de la matrice.

## Revendications

1. Structure électronique (4) comprenant une pluralité de dispositifs électroniques (411) agencés sous la forme d'une matrice (41) comportant un premier nombre (N1) de lignes (Lⱼ), les dispositifs électroniques de chaque ligne étant connectés en série, la matrice comportant en outre une pluralité de commutateurs (412) et les lignes de la matrice étant réparties en un deuxième nombre (N2) de groupes (Gₖ) étant connectés en série au moyen des commutateurs (412), les groupes (Gₖ) connectés en série étant alimentés par un courant d'alimentation électrique, au moins l'un des groupes comportant au moins deux lignes connectées en parallèle de manière à répartir le courant d'alimentation entre lesdites au moins deux lignes.

2. Structure (4) selon la revendication 1 **caractérisée en ce que** la structure comporte un dispositif de contrôle (42) pilotant les commutateurs de la matrice (41) pour connecter en série les groupes (Gₖ) selon un ordre prédéterminé, chaque groupe comportant un nombre de lignes (Lⱼ) connectées en parallèles décroissant selon l'ordre dans lequel les groupes sont connectés en série.

3. Structure (4) selon l'une quelconque des revendications 1 et 2 **caractérisée en ce que** les groupes (Gₖ) sont formés par des lignes (Lⱼ) adjacentes.

4. Structure (4) selon l'une quelconque des revendications 1 à 3 **caractérisée en ce que** la matrice (41) comporte au moins deux fois plus de lignes (Lⱼ) que de groupes (Gₖ).

5. Structure (4) selon l'une quelconque des revendications 1 à 4 **caractérisée en ce que** le premier nombre (N1) de lignes (Lⱼ) de la matrice (41) est un nombre multiple entier du deuxième nombre (N2) de groupes (Gₖ).

6. Structure (4) selon l'une quelconque des revendications 1 à 5 **caractérisée en ce que** la matrice (41) consomme une puissance électrique totale, le premier nombre (N1) de lignes (Lⱼ) de la matrice (41) étant suffisamment élevé pour que chaque groupe (Gₖ) consomme une puissance électrique moyenne telle que l'écart entre la puissance totale divisée par le nombre de groupes et la puissance de chaque groupe est inférieur à 40%.

7. Structure (4) selon l'une quelconque des revendications 1 à 6 **caractérisée en ce que** les dispositifs électroniques (411) sont des dispositifs émetteurs de lumière.

8. Structure (4) selon la revendication 7 **caractérisée en ce que** les dispositifs émetteurs de lumière (411) sont des diodes électroluminescentes planaires.

9. Structure (4) selon la revendication 7 **caractérisée en ce que** les dispositifs émetteurs de lumière (411) sont des diodes électroluminescentes à nano ou à micro-fils.

## Patentansprüche

1. Elektronische Struktur (4), umfassend eine Vielzahl von elektronischen Vorrichtungen (411), die in Form einer Matrix (41) angeordnet sind, umfassend eine erst Anzahl (N1) von Leitungen (Lⱼ), wobei die elektronischen Vorrichtungen jeder Leitung in Serie angeschlossen sind, wobei die Matrix darüber hinaus eine Vielzahl von Schaltern (412) umfasst und die Leitungen der Matrix in einer zweiten Anzahl (N2) von Gruppen (G_{K}) unterteilt sind, die in Serie mittels Schaltern (412) angeschlossen sind, wobei die in Serie angeschlossenen Gruppen (G_{K}) mit einem elektrischen Strom versorgt sind, wobei wenigstens eine der Gruppen wenigstens zwei parallel derart angeschlossene Leitungen aufweist, dass der Versorgungsstrom zwischen den genannten wenigstens zwei Leitungen aufgeteilt ist.

2. Struktur (4) gemäß Anspruch 1, **dadurch gekennzeichnet, dass** die Struktur eine Steuervorrichtung (42) umfasst, die die Schalter der Matrix (41) steuert, um die Gruppen (GK) gemäß einer vorbestimmten Reihenfolge in Serie anzuschließen, wobei jede Gruppe eine Anzahl von Leitungen (Lj) umfasst, die gemäß der Reihenfolge, in der die Gruppen in Serie angeschlossen sind, absteigend parallel angeschlossen sind.

3. Struktur (4) gemäß irgendeinem der Ansprüche 1 und 2, **dadurch gekennzeichnet, dass** die Gruppen (GK) durch angrenzende Leitungen (Lj) gebildet sind.

4. Struktur (4) gemäß irgendeinem der Ansprüche 1 bis 3, **dadurch gekennzeichnet, dass** die Matrix (41) wenigstens zweimal mehr Leitungen (Lj) als Gruppen (GK) umfasst.

5. Struktur (4) gemäß irgendeinem der Ansprüche 1 bis 4, **dadurch gekennzeichnet, dass** die erste Anzahl (N1) von Leitungen (Lj) der Matrix (41) eine ganze vielfache Anzahl der zweiten Anzahl (N2) von Gruppen (Gk) ist.

6. Struktur (4) gemäß irgendeinem der Ansprüche 1 bis 5, **dadurch gekennzeichnet, dass** die Matrix (41) eine elektrische Gesamtleistung verbraucht, wobei die erste Anzahl (N1) von Leitungen (Lj) der Matrix (41) ausreichend hoch ist, damit jede Gruppe (Gk) eine durchschnittliche elektrische Leistung derart verbraucht, dass der Unterschied der Gesamtleistung, geteilt durch die Anzahl von Gruppen, und der Leistung jeder Gruppe geringer ist als 40 %.

7. Struktur (4) gemäß irgendeinem der Ansprüche 1 bis 6, **dadurch gekennzeichnet, dass** die elektronischen Vorrichtungen (411) Lichtausgabevorrichtungen sind.

8. Struktur (4) gemäß Anspruch 7, **dadurch gekennzeichnet, dass** die Lichtausgabevorrichtungen (411) planare Leuchtdioden sind.

9. Struktur (4) gemäß Anspruch 7, **dadurch gekennzeichnet, dass** die Lichtausgabevorrichtungen (411) Leuchtdioden mit Nano- oder Mikrodrähten sind.

## Claims

1. Electronic structure (4) comprising a plurality of electronic devices (411) arranged in the form of a matrix array (41) comprising a first number (N1) of rows (Lⱼ), the electronic devices of each row being connected in series, the matrix array further comprising a plurality of switches (412) and the rows of the matrix array being distributed in a second number (N2) of groups (Gₖ) being connected in series by means of the switches (412), the groups (Gₖ) connected in series being supplied with an electrical supply current, at least one of the groups comprising at least two rows connected in parallel so as to distribute the supply current between said at least two rows.

2. Structure (4) according to claim 1 **characterised in that** the structure comprises a control device (42) controlling the switches of the matrix array (41) to connect in series the groups (Gₖ) according to a predetermined order, each group comprising a number of rows (Lⱼ) connected in parallel decreasing according to the order in which the groups are connected in series.

3. Structure (4) according to any of claims 1 and 2 **characterised in that** the groups (Gₖ) are formed by adjacent rows (Lⱼ).

4. Structure (4) according to any of claims 1 to 3 **characterised in that** the matrix array (41) comprises at least two times more rows (Lⱼ) than groups (Gₖ).

5. Structure (4) according to any of claims 1 to 4 **characterised in that** the first number (N1) of rows (Lⱼ) of the matrix array (41) is a multiple integer of the second number (N2) of groups (Gₖ).

6. Structure (4) according to any of claims 1 to 5 **characterised in that** the matrix array (41) consumes a total electrical power, the first number (N1) of rows (Lⱼ) of the matrix array (41) being sufficiently high so that each group (Gₖ) consumes an average electrical power such that the difference between the total power divided by the number of groups and the power of each group is less than 40%.

7. Structure (4) according to any of claims 1 to 6 **characterised in that** the electronic devices (411) are light emitting devices.

8. Structure (4) according to claim 7 **characterised in that** the light emitting devices (411) are planar light emitting diodes.

9. Structure (4) according to claim 7 **characterised in that** the light emitting devices (411) are nanowire or microwire light emitting diodes.
